# EUROPÄISCHE PATENTSCHRIFT

(11) **EP 2 853 908 B1**
(45) Veröffentlichungstag und Bekanntmachung des Hinweises auf die Patenterteilung: **31.03.2021**
(21) Anmeldenummer: 13004654.3
(22) Anmeldetag: 25.09.2013
(51) Int. Cl.: G01R 31/50, G01R 31/14, G01R 31/62

(54) **Prüfsystem für Hochspannungskomponenten**
Test system for high voltage components
Système de contrôle pour composants haute tension

(43) Veröffentlichungstag der Anmeldung: 01.04.2015
(73) Patentinhaber: ABB Power Grids Switzerland AG, 5400 Baden (CH)
(72) Erfinder: Szczechowski, Janusz, 04229 Leipzig (DE); Steiger, Matthias, 06808 Bitterfeld-Wolfen OT Holzweißig, (DE)
(74) Vertreter: Vossius & Partner Patentanwälte Rechtsanwälte mbB

(56) Entgegenhaltungen:
- EP-A1- 2 590 185
- EP-A1- 2 590 490
- WO-A1-2007/001024

## Beschreibung

Die Erfindung betrifft ein Prüfsystem für Hochspannungskomponenten, umfassend mehrere Systemkomponenten, darunter wenigstens einen Wechselrichter und einen HV-Filter.

Es ist allgemein bekannt, dass Hochspannungskomponenten, wie beispielsweise Leistungstransformatoren, einem Alterungsprozess unterworfen sind, welcher insbesondere die elektrische Isolation betrifft. Leistungstransformatoren weisen beispielsweise eine Nennleistung von einigen MVA bis 100MVA und darüber auf. Typische Nennspannungen liegen im Bereich von 10kV bis 110kV und darüber. Von daher sind zur Sicherstellung eines fehlerfreien Betriebes eines elektrischen Energieverteilungsnetzes mit derartigen Hochspannungskomponenten in bestimmten Zeitintervallen Prüfungen, insbesondere der Leistungstransformatoren, sinnvoll. Eine derartige Prüfung ist auch nach einer Reparatur oder Wartung eines Transformators sinnvoll bzw. erforderlich. Derartige Prüfungen geben Aufschluss über den Zustand beispielsweise der Isolation und ermöglichen auch die Detektion anderer Fehler der betreffenden Hochspannungskomponente.

Hochspannungskomponenten wie Leistungstransformatoren weisen ein hohes Gewicht auf. Ein Transport eines derartigen innerhalb eines elektrischen Energieverteilungsnetzes eingebauten Leistungstransformators in ein fest installiertes Prüffeld, in welchem dieser mittels einer Wechselspannungsprüfung geprüft werden könnte, ist sowohl aufgrund des hohen Transportaufwandes für den jeweiligen Leistungstransformator als auch aufgrund mangelnder Redundanz im jeweiligen Energieverteilungsnetz in den allermeisten Fällen ausgeschlossen. Aus diesem Grund erfolgen derartige Wechselspannungsprüfungen von Leistungstransformatoren zumeist vor Ort.

Als nachteilig erweist es sich, dass bekannte Prüfsysteme für Hochspannungskomponenten, beispielsweise im Bereich von 10kV bis 110kV, zumeist als lose Systemkomponenten in einem oder auch mehreren Frachtcontainern vor Ort transportiert werden, wobei die Systemkomponenten dann vor Ort mit entsprechenden Hubwerkzeugen aus dem Frachtcontainer entfernt, bis zur zu prüfenden Komponente verbracht und dort sehr aufwändig zu einem Prüfsystem verschaltet werden müssen.

Im Stand der Technik sind weiterhin Testsysteme für Höchstspannungskomponenten, beispielsweise im Bereich von 110kV bis 380kV, bekannt, welche komplett in einem Frachtcontainer integriert sind. Ein derartiger Frachtcontainer ist jedoch zumindest für den Test von kleineren oder mittleren Hochspannungskomponenten, welche zumeist in eher beengten Raumverhältnissen angeordnet sind, aufgrund seiner Größe zumeist nicht direkt zum Prüfort verbringbar. Ein Beispiel für ein derartiges System ist in der EP 2133704 B1 beschrieben.

Das Patentdokument EP 2 590 490 A1 offenbart einen Prüfcontainer mit Wärme erzeugenden Komponenten eines modularen Transformatorprüfystems mit einem integrierten Kühlsystem, welches einen aus dem Container herausfahrbaren Wärmetauscher aufweist.

Ausgehend von diesem Stand der Technik ist es Aufgabe der Erfindung, ein Prüfsystem für Hochspannungskomponenten bereitzustellen, welches einfach transportierbar ist, sich auch unter beengten Raumverhältnissen besonders einfach vor Ort aufbauen lässt und welches darüber hinaus besonders flexibel handhabbar ist.

Diese Aufgabe wird gelöst von einem Prüfsystem für Hochspannungskomponenten gemäß Anspruch 1.

Die Grundidee der Erfindung besteht darin, ein Prüfsystem für Hochspannungskomponenten modularisiert zu gestalten und jeweilige Systemkomponenten als Module fest in einem jeweiligen quaderähnlichen Transportbehälter anzuordnen, welcher mit entsprechenden Standardverbindungselementen ausgestattet ist. So lassen sich in vorteilhafter Weise die einzelnen Transportbehälter einfach handhaben und müssen vor Ort lediglich noch über ihre Standardverbindungselemente zu einem funktionierenden Prüfsystem miteinander verbunden werden. Ein Aufbau vor Ort ist hierdurch in vorteilhafter Weise vereinfacht. Die Transportbehälter erfüllen dann nicht nur während des Transportes sondern auch während der Prüfung eine Schutzfunktion.

Eine manuelle Tragbarkeit eines Behälters bedeutet automatisch auch eine Gewichtsbeschränkung, beispielsweise auf einen Gewichtsbereich von maximal 100kg oder 150kg, welcher von 3 Personen durchaus noch zu bewältigen ist. Aber auch ein Transportbehälter mit einem Gewicht von beispielsweise 200kg ist durchaus noch als von 4 Personen tragbar anzusehen. Dies bedeutet, dass letztendlich das Gewicht einer als ein Modul ausgeführten Systemkomponente wie einer Drossel oder einem Anpasstransformator begrenzt ist. Damit liegt das Hauptanwendungsgebiet eines erfindungsgemäßen Prüfsystems bei der Prüfung von Hochspannungskomponenten im Bereich von 10kV bis 110kV, weil dort das Gewicht der jeweiligen Systemkomponenten in der Regel einen tragbaren Gewichtsbereich nicht übersteigt. Je nach Prüfanwendung lassen sich aber auch Prüfsysteme für beispielsweise 380kV derartig ausgestalten.

Darüber liegende Spannungsbereiche von beispielsweise 380kV und höher, bei welchen die jeweilige Systemkomponenten eines Prüfsystems deutlich schwerer sein können als der tragbare Gewichtsbereich, sind jedoch auch eher uninteressant für ein erfindungsgemäßes Prüfsystem, weil in solchen Spannungsebenen zumeist eine so gute örtliche Zugänglichkeit einer zu testenden Hochspannungskomponente gegeben ist, dass beispielsweise ein Frachtcontainer mit fest integriertem Prüfsystem problemlos direkt an diese verbringbar ist.

Durch den modularen Aufbau eines erfindungsgemäßen Prüfsystems ergeben sich zudem hohe Flexibilitätsvorteile. So lässt sich beispielsweise durch entsprechende elektrische Parallelschaltung von in jeweiligen Transportbehältern angeordneten standardisierten Wechselrichtermodulen ein Wechselrichter mit entsprechend bedarfsgerecht erhöhter Leistung als Systemkomponente bilden. Auch die wahlweise ein- oder mehrphasige Ausführung eines erfindungsgemäßen Prüfsystems ist damit in vorteilhafter Weise ermöglicht. Somit lässt sich je nach durchzuführender Prüfung aus jeweiligen zur Verfügung stehenden Modulen ein bedarfsgerechtes Prüfsystem konzipieren, welches besonders einfach auch bei schlechter Zugänglichkeit einer zu prüfenden Hochspannungskomponente dorthin verbringbar und mit wenig Aufwand dort aufbaubar ist.

Um den sicheren Betrieb des Prüfsystems mit in den Transportbehältern angeordneten Systemkomponenten zu ermöglichen ist es erfindungsgemäß in einer Variante vorgesehen, die Systemkomponenten derart in den jeweiligen Transportbehältern anzuordnen, dass genügend große Isolationsabstände zu spannungsführenden beziehungsweise geerdeten Bauteilen gewährleistet sind. Während beispielsweise Wechselrichtermodule typischerweise bereits in einem Gehäuse angeordnet sind, welches seinerseits in einem Transportbehälter angeordnet ist, so dass keine Isolationsprobleme zu erwarten sind, ist beispielsweise bei einem Anpasstransformator auf entsprechende Abstände, beispielsweise zu den Wandungen des Transportbehälters, zu achten. Die innerhalb eines Transportbehälters benötigten Isolationsabstände lassen sich jedoch durch entsprechende Isolationsmaßnahmen, wie beispielsweise einer Verlängerung eines Kriechweges oder Schirmungen, reduzieren.

Gemäß einer weiteren Ausgestaltungsform des erfindungsgemäßen Prüfsystems werden als Standardverbindungselemente für elektrische Verbindungen steckbare Verbindungselemente verwendet, beispielsweise *MC* oder *Hartling* Verbindungen. Diese haben sich als ein jeweiliger Standard etabliert und weisen entsprechend gute Verbindungseigenschaften auf. Elektrische Verbindungen können beispielsweise sowohl Datenverbindungen zum Steuern der einzelnen Systemkomponenten sein als auch Leitungen zur Übertragung von beispielsweise einer Prüfspannung.

Gemäß einer besonders bevorzugten Ausgestaltungsform des erfindungsgemäßen Prüfsystems ist als eine Systemkomponente eine in einem separaten Transportbehälter angeordnete Kühlvorrichtung vorgesehen, welche mittels Schlauchverbindungen mit wenigstens einem der anderen Transportbehälter verbindbar ist, so dass eine darin angeordnete Systemkomponente dadurch kühlbar ist. Wechselrichter beispielsweise geben während ihres Betriebes eine nicht unerhebliche Verlustwärme ab, welche entsprechend abzuführen ist. In gewissen Grenzen lässt sich diese beispielsweise mittels eines in einer Wandung eines Transportbehälters vorgesehenen Lüftungsgitters abführen, die wärmetechnische Verschaltung mit einem Kühlsystem ist jedoch als deutlich effektiver anzusehen.

Auch hier wird die außerordentlich hohe Flexibilität eines erfindungsgemäßen Prüfsystems deutlich. Wenn eine Prüfung beispielsweise unter sehr gemäßigten Klimabedingungen, beispielsweise im Winter, erfolgen soll kann gegebenenfalls auf ein Kühlsystem verzichtet werden, wohingegen unter sehr extremen Klimabedingungen sogar mehrere Kühlsysteme vorgesehen sein können.

In einer weiterhin bevorzugten Ausgestaltungsform des erfindungsgemäßen Prüfsystems ist als eine der Systemkomponenten ein Anpasstransformator vorgesehen. Durch Verwendung eines Anpasstransformators lässt sich das Spannungsniveau einer von einem oder mehreren Wechselrichtern erzeugten Prüfspannung bedarfsgerecht erhöhen. Ein Anpasstransformator ist ebenfalls eine Komponente, welche sich innerhalb eines Transportbehälters anordnen lässt.

Gemäß einer weiteren erfindungsgemäßen Variante des Prüfsystems ist eine Systemkomponente auf mehrere Transportbehälter verteilt. Dies können beispielsweise mehrere in Reihe oder parallel geschaltete Wechselrichtermodule sein, durch welche gemeinsam eine Systemkomponente mit entsprechend höherer Leistung gebildet ist. Aber auch Systemkomponenten wie HV-Filter oder Anpasstransformatoren lassen sich bedarfsweise auf mehrere miteinander verschaltete Module verteilen, welche in jeweiligen Transportbehältern angeordnet sind. Hierdurch lassen sich letztendlich auch Systemkomponenten realisieren, deren Gesamtgewicht ein manuell tragbares Gewicht übersteigt. Die Gesamtleistung eines Prüfsystems kann damit in vorteilhafter Weise gesteigert werden.

Einer weiteren Erfindungsvariante folgend ist auch die Möglichkeit vorgesehen, dass mehrere Systemkomponenten in einem einzigen Transportbehälter angeordnet sind. Dies ist insbesondere bei kleineren Systemkomponenten sinnvoll, welche gut zusammen anordenbar sind und funktionell zusammengehören. Ein Beispiel hierfür kann beispielsweise ein Steuerrechner für ein Prüfsystem sein, welcher zusammen mit einer Auswertevorrichtung in ein und demselben Transportbehälter angeordnet ist.

Eine weitere Erfindungsvariante ist dadurch gekennzeichnet, dass zumindest einige der Transportbehälter von ihrer äußeren Geometrie her identisch sind. Dadurch lassen diese sich sowohl beim Transport als auch beim Betrieb des Prüfsystems platzsparend anordnen, beispielsweise in Form eines Stapels.

Um eine Stapelbarkeit weiter zu verbessern ist erfindungsgemäß in einer Variante vorgesehen, dass zumindest einige der Transportbehälter formschlüssig stapelbar sind. Dies bedeutet beispielsweise, dass entsprechende Stapelmulden oder dergleichen vorgesehen sind, so dass eine gegenseitige horizontale Fixierung übereinander gestapelter Transportbehälter gegeben ist.

Gemäß einer weiterhin bevorzugten Variante des Prüfsystems sind jeweilige zu verbindende korrespondierende Standardverbindungselemente verschiedener Transportbehälter derart in deren jeweiligen Deckel- beziehungsweise Bodenbereichen angeordnet, dass im gestapelten Zustand der Transportbehälter bereits eine jeweilige Verbindung gebildet ist. Somit wird eine Verbindung verschiedener Transportbehälter weiter vereinfacht, weil bereits beim Stapelvorgang automatisch eine entsprechende Verbindung gebildet ist, ohne dass ein sonst übliches Verbindungsstück, beispielsweise ein Kabel- oder Schlauchstück, erforderlich sind.

Um die volle Betriebsfähigkeit eines erfindungsgemäßen Prüfsystems herzustellen sind die Systemkomponenten über die Standardverbindungselemente miteinander verbunden. Gegebenenfalls ist es auch möglich beziehungsweise isolationstechnisch sogar erforderlich, einige Komponenten wie einen Überspannungsableiter oder dergleichen nicht in einem Transportbehältnis sondern alleinstehend im Prüfaufbau zu betreiben.

Einer weiteren Erfindungsvariante folgend weisen zumindest einige der Transportbehälter äußere Tragegriffe auf, mit welchen der manuelle Transport vorteilhaft vereinfacht ist. Transportbehälter sind beispielsweise aus Aluminium gefertigt, welches zur Erhöhung der Stabilität eine Profilstruktur aufweisen kann,

Weitere vorteilhafte Ausgestaltungsmöglichkeiten sind den weiteren abhängigen Ansprüchen zu entnehmen.

Anhand der in den Zeichnungen dargestellten Ausführungsbeispiele sollen die Erfindung, weitere Ausführungsformen und weitere Vorteile näher beschrieben werden.

Es zeigen:
- Fig. 1: ein exemplarisches Prüfsystem für Hochspannungskomponenten,
- Fig. 2: eine Schnittansicht durch einen ersten exemplarischen Transportbehälter,
- Fig. 3: eine Außenansicht von einem zweiten exemplarischen Transportbehälter und
- Fig. 4: eine Verschaltung eines exemplarischen Prüfsystems.

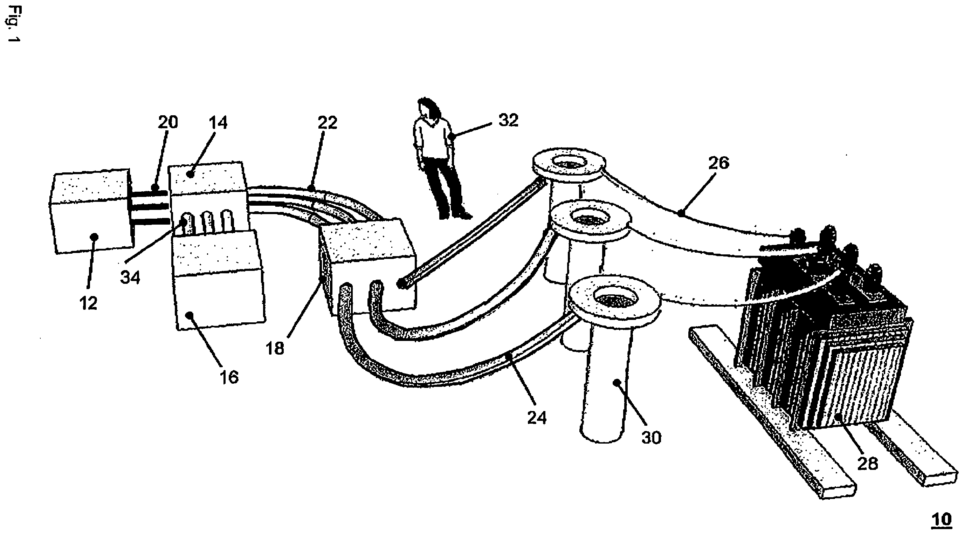

Figur 1 zeigt ein exemplarisches Prüfsystem für Hochspannungskomponenten in einer dreidimensionalen Ansicht 10. Das Prüfsystem weist vier Transportbehälter 12, 14, 16, 16 auf, wobei in deren Inneren angeordnete Systemkomponenten mittels jeweiliger Verbindungen elektrisch 20, 22, 34 miteinander verbunden sind. Das Prüfsystem weist als Systemkomponenten zwei Wechselrichter, einen HV-Filter sowie einen Anpasstransformator auf, was der Figur aufgrund der außen nahezu identisch ausgestalteten Transportbehälter jedoch nicht direkt entnehmbar ist. Eine über elektrische Verbindungsleitungen erfolgende Energieversorgung des Prüfsystems ist ebenfalls nicht gezeigt. An den als Ausgänge fungierenden Standardverbindungselementen des vierten Transportbehälters 18 liegt im Prüfbetrieb eine Prüfspannung an, welche mittels der Verbindung 24, 26 und über jeweilige Spannungsteiler 30 zu einem zu prüfenden Hochspannungstransformator geführt wird.

Eine als Größenmaßstab dargestellte Bedienperson 32 zeigt die Dimensionen dieses exemplarischen Prüfsystems. Es ist gut ersichtlich, dass die Transportbehälter von der Größe her gut von 2 bis 3 Personen getragen werden können und damit besonders flexibel und ohne Zuhilfenahme von Hubwerkzeugen oder dergleichen vor Ort aufgebaut werden können. Eine gestapelte Anordnung von Transportbehältern ist in dieser Figur nicht dargestellt. Bei der Verteilung und Anordnung der jeweiligen Systemkomponenten auf beziehungsweise in den jeweiligen Transportbehältern wurde darauf geachtet, dass ein tragbares Gewicht nicht überschritten wird.

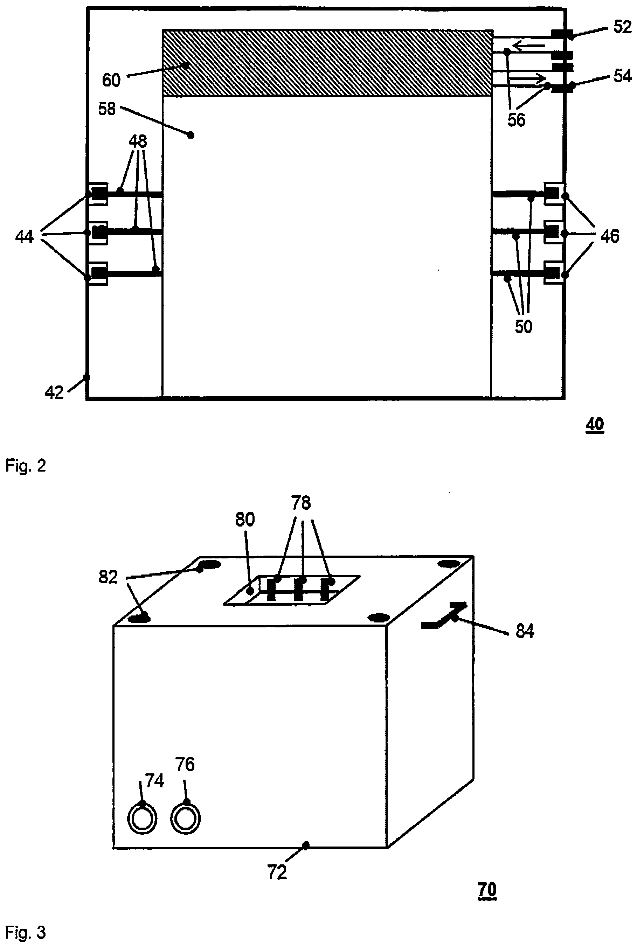

Figur 2 zeigt eine Schnittansicht 40 durch einen ersten exemplarischen Transportbehälter 42. In dem quaderförmigen Transportbehälter 42 ist ein in einem ebenfalls quaderförmigen Gehäuse angeordneter Wechselrichter 58 vorgesehen. Dieser ist elektrisch mittels interner Verbindungsleitungen 48, 50 mit an den Seitenwandungen des Transportbehälters 42 vorgesehenen Standardverbindungselementen 44, 46 verbunden, welche beispielsweise ein jeweiliges Kupplungsstück zum Anschluss einer Verbindungsleitung darstellen. Eventuelle elektrische Steuerleitungen zu einem Steuersystem sind nicht dargestellt, diese sind aber beispielsweise ebenfalls durch nicht gezeigte Standardverbindungselemente in den Transportbehälter einführbar, es ist aber auch beispielsweise eine Glasfaser- oder Funkverbindung möglich.

Da der Wechselrichter 58 im Prüfbetrieb eine aus elektrischen Verlusten resultierende Wärmeleistung abgibt, ist oberhalb ein Wärmetauscher 60 eines Kühlsystems vorgesehen, um die Wärmeleistung abzuführen. Der Wärmetauscher ist Teil eines zu bildenden Kühlsystems mit geschlossenem Kühlkreislauf, welcher neben einem Kühlaggregat in einem nicht gezeigten benachbarten Transportbehälter auch innere Verbindungsrohre 56 und Standardverbindungselemente 52, 54 für Zu- und Ablauf eines Kühlmediums umfasst.

Figur 3 zeigt eine Außenansicht 70 von einem zweiten exemplarischen Transportbehälter 72. Dieser weist an einer seiner Seitenwandungen zwei Standardverbindungselemente 74, 76 eines Kühlmittelein- beziehungsweise Auslasses zum Anschluss eines jeweiligen Verbindungsschlauches auf. An zwei gegenüberliegenden Seitenwandungen sind jeweils ein Tragegriff 84 vorgesehen, von denen aus zeichnerischen gründen jedoch nur einer sichtbar ist.

Im Deckelbereich des Transportbehälters 72 ist eine quaderähnliche Ausnehmung beziehungsweise Vertiefung vorgesehen, aus welcher ihrerseits drei Standardverbindungselemente 78 herausragen. Nicht sichtbar auf der Unterseite des Transportbehälters 72 ist ein entsprechendes Gegenverbindungsstück vorgesehen, so dass bei Stapeln gleichartiger Transportbehälter 72 automatisch eine jeweilige Verbindung gebildet ist. Um bei einem derartigen Stapel von Transportbehältern 72 ein gegenseitiges horizontales Verrutschen zu vermeiden, sind an der Ober- und Unterseite jeweils formschlüssig korrespondierende Stapelmulden 82 vorgesehen.

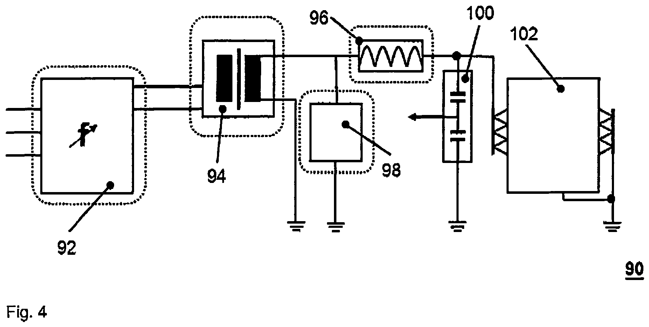

Figur 4 zeigt eine elektrische Verschaltung 90 eines exemplarischen Prüfsystems mit seinen jeweiligen Systemkomponenten. Ein über eine dreiphasige Versorgungsspannung gespeister Wechselrichter 92 erzeugt eine Wechselspannung variabler Frequenz. Diese wird einem Anpasstransformator 94 zugeführt und auf ein höheres Spannungsniveau transformiert. Die hochtransformierte Spannung wird mittels eines HV Filters 98 gefiltert und über eine Drossel 96 einem zu prüfenden Transformator 102 zugeführt. Ein Spannungsteiler dient ebenfalls als Filter und teilt die Spannung auf einen messbaren Wert runter. Am Spannungsabgriff ist eine nicht gezeigte Spannungsmessvorrichtung vorgesehen, deren ermittelte Spannungswerte einem nicht gezeigten Auswertesystem zugeführt werden, beispielsweise einer geeigneten Datenverarbeitungsanlage.

### Bezugszeichentiste

- 10: exemplarisches Prüfsystem für Hochspannungskomponenten
- 12: erster Transportbehälter von Prüfsystem
- 14: zweiter Transportbehälter von Prüfsystem
- 16: dritter Transportbehälter von Prüfsystem
- 18: vierter Transportbehälter von Prüfsystem
- 20: erste Verbindungen zwischen Standardverbindungselementen
- 22: zweite Verbindungen zwischen Standardverbindungselementen
- 24: dritte Verbindungen zwischen Standardverbindungselementen
- 26: vierte Verbindungen zwischen Standardverbindungselementen
- 28: zu prüfender Hochspannungstransformator
- 30: Spannungsteiler
- 32: Bedienperson
- 34: fünfte Verbindungen zwischen Standardverbindungselementen
- 40: Schnittansicht durch ersten exemplarischen Transportbehälter
- 42: erster exemplarischer Transportbehälter
- 44: erste Standardverbindungselemente
- 46: zweite Standardverbindungselemente
- 48: erste interne Verbindungen
- 50: zweite interne Verbindungen
- 52: Standardverbindungselement von Kühlmitteleinlass
- 54: Standardverbindungselement von Kühlmittelauslass
- 56: Verbindungsrohre
- 58: Wechselrichter
- 60: Wärmetauscher
- 70: Außenansicht von zweitem exemplarischen Transportbehälter
- 72: zweiter exemplarischer Transportbehälter
- 74: Standardverbindungselement von Kühlmitteleinlass
- 76: Standardverbindungselement von Kühlmittelauslass
- 78: exemplarische Standardverbindungselemente
- 80: Ausnehmung in Deckelbereich von zweitem Transportbehälter
- 82: Staplelmulden
- 84: Tragegriff
- 90: Verschaltung eines exemplarischen Prüfsystems
- 92: Wechselrichter
- 94: Anpasstransformator
- 96: Drossel
- 98: HV-Filter
- 100: Spannungsteiler
- 102: zu prüfender Hochspannungstransformator

## Patentansprüche

1. Prüfsystem (10, 90) für Hochspannungskomponenten, umfassend mehrere Systemkomponenten, darunter wenigstens einen Wechselrichter (58, 92) und einen HV-Filter (98), *wobei* die Systemkomponenten zumindest überwiegend derart auf mehrere geschlossene quaderähnliche Transportbehälter (12, 14, 16, 18, 42, 72) verteilt und fest darin angeordnet sind, dass diese jeweils manuell tragbar sind *und* wobei die Transportbehälter (12, 14, 16, 18, 42, 72) durch deren Wandung geführte Standardverbindungselemente (44, 46, 52, 54, 74, 76, 78) zur Verschaltung der Systemkomponenten aufweisen
wobei
*als eine Systemkomponente eine in einem separaten Transportbehälter (12, 14, 16, 18, 42, 72) angeordnete Kühlvorrichtung vorgesehen ist, welche mittels Schlauchverbindungen mit wenigstens einem der anderen Transportbehälter (12, 14, 16, 18, 42, 72) verbindbar ist,* so *dass eine darin angeordnete Systemkomponente dadurch kühlbar ist.*

2. Prüfsystem nach Anspruch 1, **dadurch gekennzeichnet, dass** die Systemkomponenten derart in den jeweiligen Transportbehältern (12, 14, 16, 18, 42, 72) angeordnet sind, dass genügend große Isolationsabstände zu spannungsführenden beziehungsweise geerdeten Bauteilen gewährleistet sind und so im verschalteten Zustand ein sicherer Prüfbetrieb gewährleistet ist.

3. Prüfsystem nach Anspruch 1 oder 2, **dadurch gekennzeichnet, dass** als Standardverbindungselemente (44, 46, 52, 54, 74, 76, 78) für elektrische Verbindungen steckbare Verbindungselemente verwendet werden (beispielsweise MC oder Hartling).

4. Prüfsystem nach einem der vorherigen Ansprüche, **dadurch gekennzeichnet, dass** als eine der Systemkomponenten ein Anpasstransformator (94) vorgesehen ist.

5. Prüfsystem nach einem der vorherigen Ansprüche, **dadurch gekennzeichnet, dass** eine Systemkomponente auf mehrere Transportbehälter (12, 14, 16, 18, 42, 72) verteilt ist.

6. Prüfsystem nach einem der vorherigen Ansprüche, **dadurch gekennzeichnet, dass** mehrere Systemkomponenten in einem einzigen Transportbehälter (12, 14, 16, 18, 42, 72) angeordnet sind.

7. Prüfsystem nach einem der vorherigen Ansprüche, **dadurch gekennzeichnet, dass** zumindest einige der Transportbehälter (12, 14, 16, 18, 42, 72) von ihrer äußeren Geometrie her identisch sind.

8. Prüfsystem nach einem der vorherigen Ansprüche, **dadurch gekennzeichnet, dass** zumindest einige der Transportbehälter formschlüssig stapelbar sind.

9. Prüfsystem nach Anspruch 8, **dadurch gekennzeichnet, dass** jeweilige zu verbindende korrespondierende Standardverbindungselemente (44, 46, 52, 54, 74, 76, 78) verschiedener Transportbehälter (12, 14, 16, 18, 42, 72) derart in deren jeweiligen Deckel- beziehungsweise Bodenbereichen angeordnet sind, dass im gestapelten Zustand der Transportbehälter (12, 14, 16, 18, 42, 72) eine jeweilige Verbindung gebildet ist.

10. Prüfsystem nach einem der vorherigen Ansprüche, **dadurch gekennzeichnet, dass** die Systemkomponenten über die Standardverbindungselemente miteinander verbunden sind.

11. Prüfsystem nach einem der vorherigen Ansprüche, **dadurch gekennzeichnet, dass** zumindest einige der Transportbehälter (12, 14, 16, 18, 42, 72) äußere Tragegriffe (84) aufweisen.

## Claims

1. Test system (10, 90) for high-voltage components, comprising a plurality of system components, including at least one inverter (58, 92) and an HV filter (98), wherein the system components are at least predominantly distributed among a plurality of closed cuboid-like transport containers (12, 14, 16, 18, 42, 72) and are permanently arranged therein in such a manner that they can each be manually carried, and wherein the transport containers (12, 14, 16, 18, 42, 72) have standard connecting elements (44, 46, 52, 54, 74, 76, 78) which are guided through their wall and which are configured to connect the system components,
wherein a cooling apparatus which is arranged in a separate transport container (12, 14, 16, 18, 42, 72) is provided as a system component and can be connected to at least one of the other transport containers (12, 14, 16, 18, 42, 72) by means of tube connections such that a system component arranged therein can be cooled thereby.

2. Test system according to claim 1, **characterized in that** the system components are arranged in the respective transport containers (12, 14, 16, 18, 42, 72) in such a manner that sufficiently large insulation distances to live or earthed components are ensured in order to ensure a safe test operation in the connected state.

3. Test system according to claim 1 or 2, **characterized in that** pluggable connecting elements (for example MC or Hartling) are used as standard connecting elements (44, 46, 52, 54, 74, 76, 78) for electrical connections.

4. Test system according to one of the preceding claims, **characterized in that** a matching transformer (94) is provided as one of the system components.

5. Test system according to one of the preceding claims, **characterized in that** a system component is distributed among a plurality of transport containers (12, 14, 16, 18, 42, 72).

6. Test system according to one of the preceding claims, **characterized in that** a plurality of system components are arranged in a single transport container (12, 14, 16, 18, 42, 72).

7. Test system according to one of the preceding claims, **characterized in that** at least some of the transport containers (12, 14, 16, 18, 42, 72) are identical in terms of their outer geometry.

8. Test system according to one of the preceding claims, **characterized in that** at least some of the transport containers can be stacked in a form-fitting manner.

9. Test system according to Claim 8, **characterized in that** respective corresponding standard connecting elements (44, 46, 52, 54, 74, 76, 78) of different transport containers (12, 14, 16, 18, 42, 72) to be connected are arranged in their respective cover or base areas in such a manner that a respective connection is formed in the stacked state of the transport containers (12, 14, 16, 18, 42, 72).

10. Test system according to one of the preceding claims, **characterized in that** the system components are connected to one another via the standard connecting elements.

11. Test system according to one of the preceding claims, **characterized in that** at least some of the transport containers (12, 14, 16, 18, 42, 72) have outer carrying handles (84).

## Revendications

1. Système de contrôle (10, 90) pour composants haute tension, comprenant plusieurs composants de système, parmi lesquels se trouve au moins un onduleur (58, 92) et un filtre HT (98), dans lequel les composants de système sont répartis au moins en majeure partie sur plusieurs conteneurs de transport (12, 14, 16, 18, 42, 72) parallélépipédiques fermés et y sont disposés solidement de telle sorte qu'il est possible de les transporter à la main respectivement, et dans lequel les conteneurs de transport (12, 14, 16, 18, 42, 72) présentent des éléments de connexion standard (44, 46, 52, 54, 74, 76, 78) guidés à travers leur paroi pour interconnecter les composants de système, dans lequel un dispositif de refroidissement disposé dans un conteneur de transport (12, 14, 16, 18, 42, 72) séparé est prévu en tant que composant de système et peut être connecté au moyen de raccordements par tuyau à au moins l'un des autres conteneurs de transport (12, 14, 16, 18, 42, 72) de sorte qu'un composant de système disposé dans celui-ci peut ainsi être refroidi.

2. Système de contrôle selon la revendication 1, **caractérisé en ce que** les composants de système sont disposés dans les conteneurs de transport (12, 14, 16, 18, 42, 72) respectifs de façon à assurer des distances d'isolation suffisamment grandes par rapport à des composants sous tension ou mis à la terre et à assurer ainsi un fonctionnement de contrôle sûr à l'état interconnecté.

3. Système de contrôle selon la revendication 1 ou 2, **caractérisé en ce que** des éléments de connexion enfichables pour des connexions électriques (par exemple MC ou Hartling) sont utilisés comme éléments de connexion standard (44, 46, 52, 54, 74, 76, 78).

4. Système de contrôle selon l'une quelconque des revendications précédentes, **caractérisé en ce qu'**un transformateur d'adaptation (94) est prévu comme l'un des composants de système.

5. Système de contrôle selon l'une quelconque des revendications précédentes, **caractérisé en ce qu'**un composant de système est réparti sur plusieurs conteneurs de transport (12, 14, 16, 18, 42, 72).

6. Système de contrôle selon l'une quelconque des revendications précédentes, **caractérisé en ce que** plusieurs composants de système sont disposés dans un seul conteneur de transport (12, 14, 16, 18, 42, 72).

7. Système de contrôle selon l'une quelconque des revendications précédentes, **caractérisé en ce qu'**au moins certains des conteneurs de transport (12, 14, 16, 18, 42, 72) sont identiques de par leur géométrie extérieure.

8. Système de contrôle selon l'une quelconque des revendications précédentes, **caractérisé en ce qu'**au moins certains des conteneurs de transport sont empilables par complémentarité de forme.

9. Système de contrôle selon la revendication 8, **caractérisé en ce que** des éléments de connexion standard (44, 46, 52, 54, 74, 76, 78) correspondants à connecter, de différents conteneurs de transport (12, 14, 16, 18, 42, 72), sont disposés dans les zones de couvercle ou de fond respectives de ceux-ci de telle sorte qu'à l'état empilé des conteneurs de transport (12, 14, 16, 18, 42, 72) une connexion respective est établie.

10. Système de contrôle selon l'une quelconque des revendications précédentes, **caractérisé en ce que** les composants de système sont reliés les uns aux autres par les éléments de connexion standard.

11. Système de contrôle selon l'une quelconque des revendications précédentes, **caractérisé en ce qu'**au moins certains des conteneurs de transport (12, 14, 16, 18, 42, 72) présentent des poignées de transport (84) extérieures.
